# EUROPEAN PATENT SPECIFICATION

(11) **EP 0 661 802 B1**
(45) Date of publication and mention of the grant of the patent: **09.09.1998**
(21) Application number: 93830541.4
(22) Date of filing: 31.12.1993
(51) Int. Cl.: H03F 1/52, H03F 1/30

(54) **Operational amplifier protection circuit using, either in working conditions or at start-up, identical circuit elements for detecting permanent output abnormal conditions**
Operationsverstärkerschutzschaltkreis, der entweder im Betrieb oder beim Einschalten die gleichen Schaltkreiselemente zur Erkennung von permanenten anormalen Ausgangszuständen benutzt
Circuit protecteur à amplification opérationnel utilisant, soit en régime normal, soit lors de la mise en marche, des mêmes éléments du circuit pour détecter des conditions de sortie anormales permanentes

(43) Date of publication of application: 05.07.1995
(73) Proprietor: STMicroelectronics S.r.l., 20041 Agrate Brianza (Milano) (IT)
(72) Inventor: Tavazzani, Claudio, I-27100 Pavia (PV) (IT); Fassina, Andrea, I-20155 Milano (IT); Stefani, Fabrizio, I-21010 Cardano (VA) (IT)

(56) References cited:
- EP-A- 0 572 755
- GB-A- 2 157 104
- US-A- 4 319 197
- US-A- 4 878 034
- PATENT ABSTRACTS OF JAPAN vol. 13, no. 378 (E-809) 22 August 1989 & JP-A-01 129 515 (MATSUSHITA) 22 May 1989
- PATENT ABSTRACTS OF JAPAN vol. 11, no. 70 (E-485) 3 March 1987 & JP-A-61 227 410 (YAESU MUSEN) 9 October 1986

## Description

The present invention relates to power amplifier protection devices and in particular a monolithically integrable protection circuit for the final stage of an audio amplifier.

In power audio amplifiers (provided in a monolithic or discrete form) the presence of devices for protection against abnormal or dangerous operating conditions for the device such as for example excessive output current or temperature is important.

One method of providing such protection consists of automatically turning off circuit portions subject to damage as soon as the abnormal condition is detected. It is therefore necessary to equip the amplifier with a circuit enabling it to operate again when the dangerous condition is later absent to avoid direct intervention by the user for turning off and restarting the device. Such a circuit is known from e.g. US-A-4 878 034.

It is becoming ever more common to equip audio amplifiers also with protection which acts during start-up. Indeed, this phase is potentially critical for the device because the partial polarisation of the final stages, typical of the start-up transition, can make ineffective the standard protection but nevertheless be dangerous for the amplifier.

This additional protection device must check the presence of any critical conditions before the final stages begin to be polarised and possibly stop the start-up sequence. A corresponding circuit is known from e.g. EP-A-0 572 755.

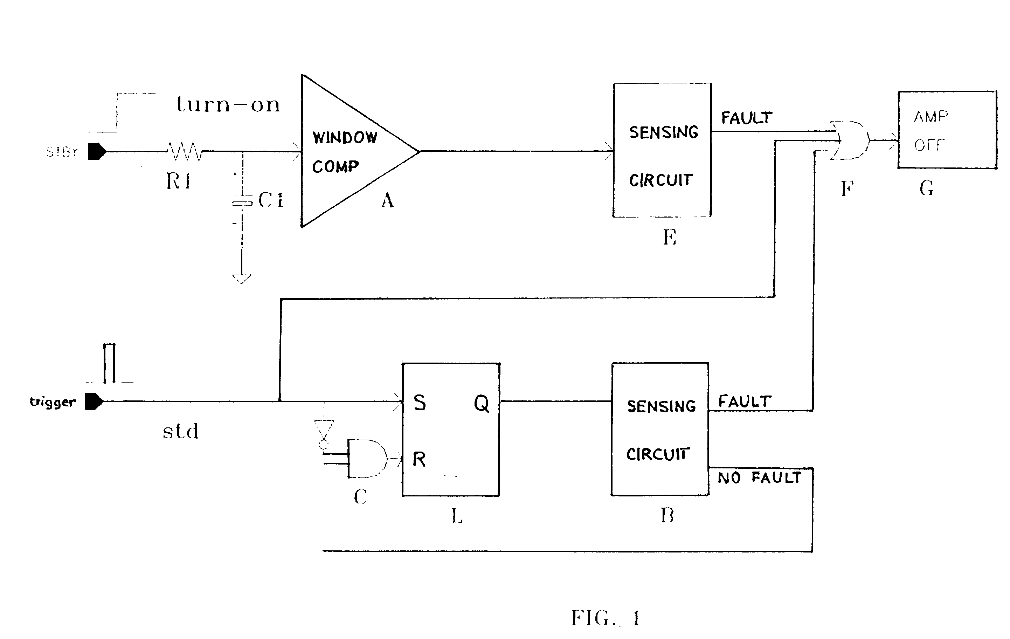

FIG. 1 of the drawings annexed to the present description shows a block diagram of a protection circuit which meets the requirements set forth above and is commonly used to protect the final stage of audio power amplifiers.

Through a type OR logic gate circuit, indicated by F, circuit switching means G for turn-off of the stage are piloted by three distinct lines.

If by circuit means (not indicated in the figures) designed to detect abnormal operating conditions there is detected for example during normal operation an overcurrent in the output elements of the stage, there is generated a so-called trigger pulse which pilots directly through the logic gate F the circuit means G for turn-off of the stage.

The same pulse pilots the input terminal S of a bistable, or flip-flop, circuit indicated by L.

The output Q of the flip-flop L also enables a sensing circuit B designed to detect the persistence of abnormal operating conditions to pilot through the logic gate F the circuit switching means G to keep the stage turned off.

The input terminal R of the flip-flop through which it is returned to the initial stable state, which is that of normal operating conditions, is connected to the output terminal of a logic gate circuit of the AND type indicated by D. Through this logic gate AND the flip-flop can receive either a pulse which is the reversed replica of the trigger pulse or a signal generated by the sensing circuit B in phase opposition to that with which the sensing circuit pilots the circuit switching means. Through the logic gate AND and the flip-flop L the sensing circuit B is disabled for keeping the stage turned off when persistence of the abnormal operating conditions ceases.

Naturally all the signals used to activate or deactivate the circuit elements just indicated are determined on the basis of the characteristics of the integrated circuit in which the protection device is included and the supply levels provided for the final stage.

Again through the type OR logic gate F, turn-off of the stage can be determined also by a second sensing circuit, indicated by E, which is enabled to detect the persistence of abnormal conditions only in the amplifier turn-on phase.

Supposing that the initial turn-on phase, which due to the presence of the active components cannot occur instantaneously, is determined by the application of a positive voltage step to the network RC of an interface of the so-called amplifier stand-by, the growing voltage at the ends of the condenser C1 is detected by a comparator A of the two-threshold and so-called window type.

Said comparator enables the second sensing circuit E only when the voltage at the ends of the condenser C1 is between a lower voltage threshold and an upper voltage threshold.

This voltage window is chosen at a voltage level lower than that at which the amplifier is turned on, to permit the sensing circuit E to complete the checks before the amplifier is capable of operating.

In the amplifiers available in trade the various circuit blocks are implemented in the different manners known to those skilled in the art.

When the amplifier has several output channels for each channel there must be provided a pair of sensing circuits: one, B, for protection during normal operation and one, E, for protection during turn-on.

The technical problem underlying the invention is to reduce the total number of circuit components and in particular of the sensing circuits and thus improve the reliability of protection and reduce the circuit integration area.

This problem is solved by a protection circuit of the type set forth above and defined by the characterising part of the claims which follow this description.

The characteristics and advantages of a protection circuit in accordance with the present invention are set forth in the description below of embodiments thereof given by way of nonlimiting example.

In the drawings:
- FIG. 1 shows a block diagram of a protection circuit for power amplifiers known to those skilled in the art,
- FIGS. 2 and 3 show the block diagrams of two embodiments of a protection circuit in accordance with the present invention, and

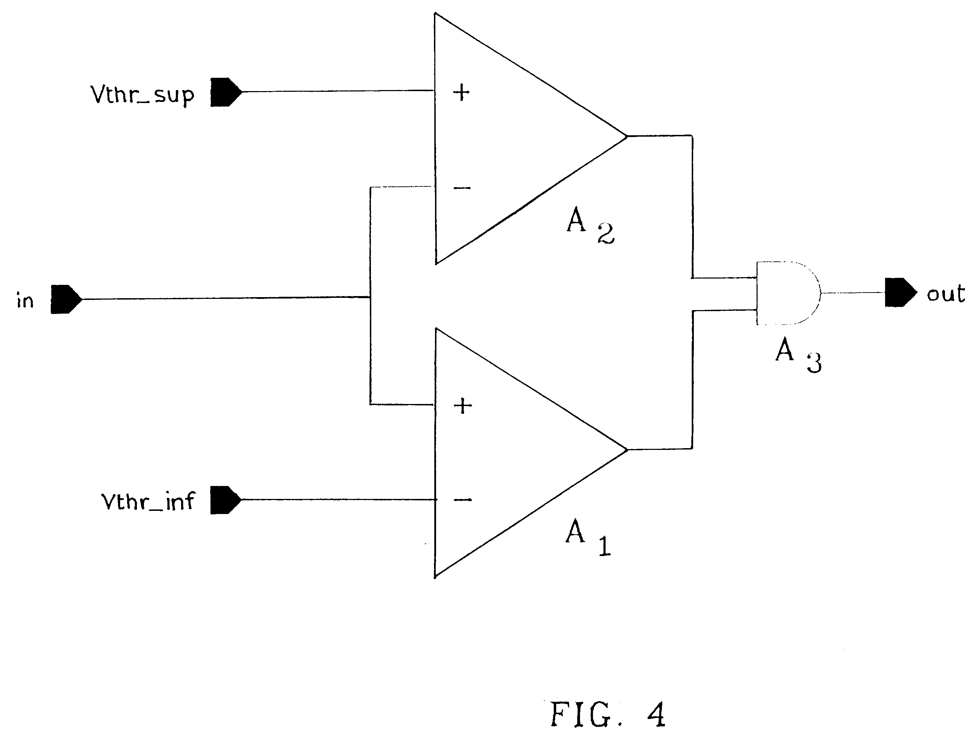

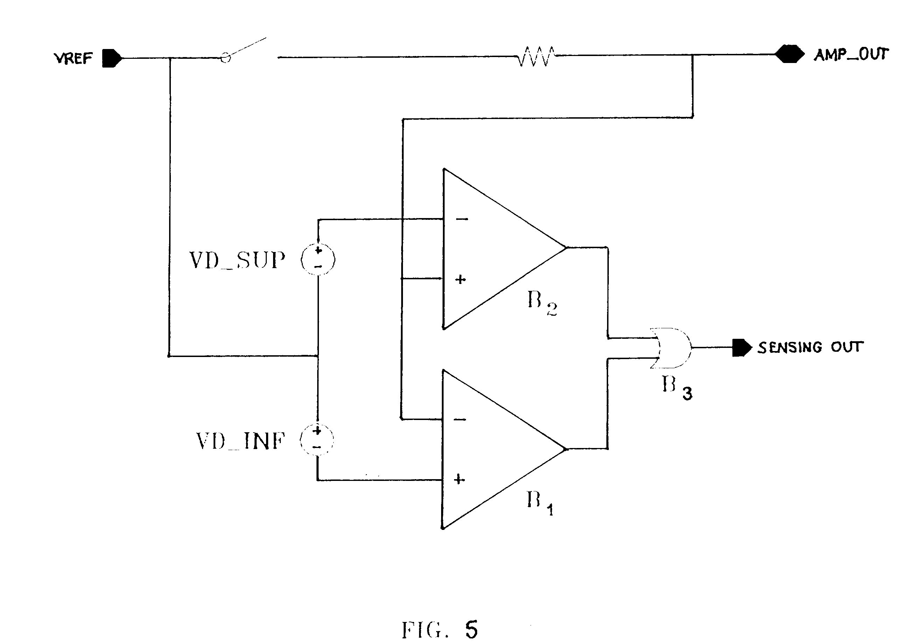

- FIGS. 4 and 5 show the circuit diagrams of possible implementations of a double-threshold and a sensing circuit respectively usable in a protection circuit in accordance with the present invention.

A protection circuit for a final stage of a power amplifier (or more generally an amplifier stage) in accordance with the present invention is characterised by a circuit structure permitting the use of a single sensing circuit for each output channel instead of two distinct sensing circuits as in the known art whether for protection during normal operation or protection upon turn-on.

As in the known protection circuit, there are provided circuit switching means G piloted through a gate OR to which however in accordance with the present invention arrive only two lines of signals, for turn-off of the amplifier stage.

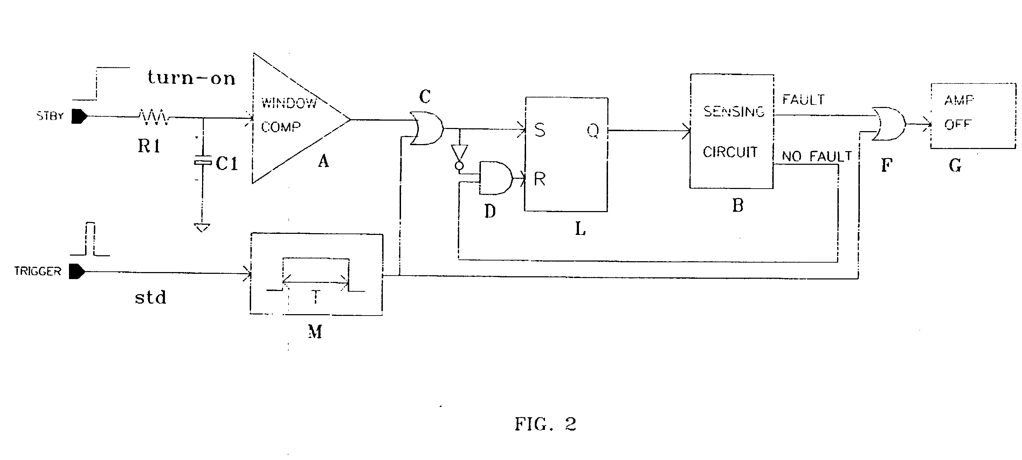

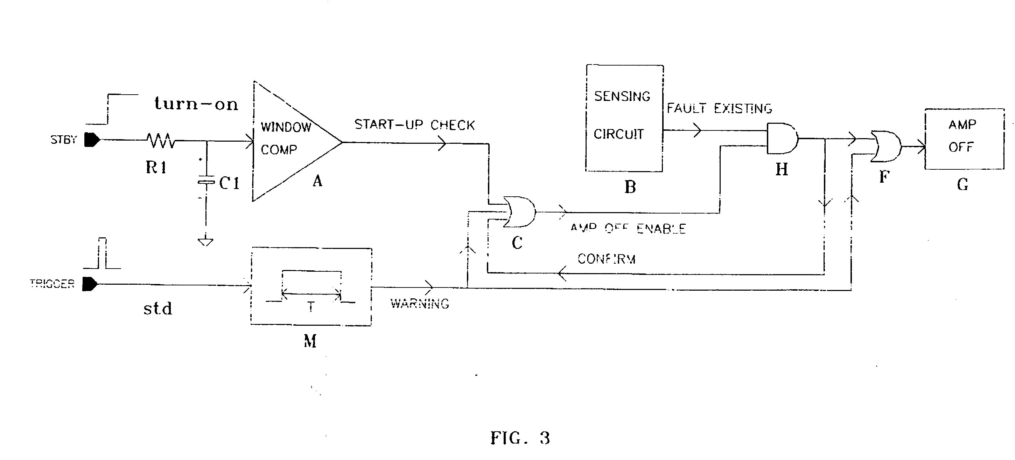

In both the block diagrams shown in FIGS. 2 and 3 there can be ideally identified a same circuit block for turn-off and restoration of normal operating conditions of the stage provided however differently in the two diagrams.

Said circuit block comprises a single sensing circuit B which in FIG. 2 is enabled by a flip-flop L to generate at the output a signal for turn-off of the stage; the configuration shown with inverter and logic gate D of the AND type connected to the terminal R is the same as that of the diagram shown in FIG. 1.

In the diagram shown in FIG. 3, which is that of a preferred embodiment, there is advantageously provided elimination of the flip-flop L and the output signal of the sensing circuit B is operated on by means of a logic gate H of the AND type.

In both cases the circuit block as a whole is designed to detect any persistence of abnormal conditions at the output of the stage by means of at least one terminal coupled with stage output elements and to generate during said conditions signals which keep the stage turned off through the logic gate F by means of the circuit switching means G.

After termination of the abnormal conditions the circuit block ceases to generate turn-off signals permitting automatic restart of the stage.

The circuit switching means can indeed be realized by simply electronic switches which, when activated under abnormal operating conditions, switch to ground the current flows of the current generators which feed the stage components. When after removal of the abnormal conditions the components are deactivated, stage operation is restored automatically.

The circuit block just indicated is enabled to generate turn-off signals by a logic gate C of type OR which has an input terminal connected to the output terminal of a double threshold comparator A and a second input terminal connected to an output terminal of a generator M of command signals for turn-off of the stage.

It is important to note that in accordance with the present invention to one input terminal for the logic gate C of type OR is also connected the output terminal of the logic gate H of the AND type.

The generator M is activated by a trigger pulse in the known manner and the command signals have a duration predetermined in time T starting from the arise of the abnormal stage operation conditions.

The output terminal of the generator M is connected directly to the circuit switching means G through the logic gate F of type OR. Said generator can be accomplished advantageously with a monostable circuit well known to those skilled in the art.

To explain in greater detail the operation of a protection circuit in accordance with the present invention reference is now made to the block diagram shown in FIG. 3, examining the status of the signals at the various points of the protection circuit in the different phases.

As mentioned, the circuit B of the block diagram of FIG. 3 checks if there are abnormal conditions in amplifier operation such as for example the persistence of a short circuit state of one or more amplifier outputs to ground or to supply, short circuit between two outputs or lack of load and so on. The output line of block B, 'fault existing', is high (i.e. 1 logic) if an abnormal condition occurs and is low (i.e. 0 logic) otherwise. The gate H of AND type enables the 'fault existing' signal to turn off the amplifier, thus placing it in a protected state, when the 'amp off enable' signal is high, i.e. when at least one of the signals at the gate of type OR, 'start-up check', 'warning' and 'confirm', is high. The above signals are in turn generated in the conditions set forth below.

The 'start-up check' signal is generated during the start-up phase of the amplifier whereas the command generally of stand-by of modern amplifiers (a positive voltage step) is set by the user. The amplifier start-up command causes a gradual increase in the voltage on the condenser C1.

As long as it is between a lower and a higher threshold of the window comparator A there is generated a signal which disappears when the voltage on C1 passes the upper threshold of the comparator A. As mentioned, the voltage window of A is placed at a lower level than that at which the amplifier starts in order to complete the checks during the starting phase before the amplifier is capable of operating.

The 'warning' signal is generated by the monostable circuit M when an anomalous event such as a short circuit current passing a given threshold occurs. A 'trigger' pulse causes starting of the monostable circuit M which generates a signal which persists for a time T, determined internally by the monostable circuit, after the end of the most recent trigger pulse.

It is well to underline the difference between a circuit which generates the trigger signal, not shown in the figures, and the sensing circuit for persistence of abnormal conditions (block B). When for example there occurs a short circuit during normal operation of the amplifier, a high current starts to run in the final power transistors and, upon passing a threshold of programmed values, a special circuit generates a trigger signal which persists all the time the current remains above the threshold. The trigger signal, through the monostable M, turns off the amplifier passing through the gate F of type OR and the circuit switcing means G and at the same time enables the circuit B to signal if the short circuit persists or has been removed. Only in the latter case the amplifier is enabled to start again.

The monostable is necessary to ensure actual turn-off of the final power transistors because it requires a time equal to that of discharge of the capacitances, parasite or not, associated with the power and piloting components of the same transistors.

The circuit M ensures persistence of a turn-off signal for a time T greater than that strictly necessary for complete turn-off, so as to eliminate the danger of reactions which would limit the current delivered without however reaching complete turn-off. The sensing circuit B for persistence of abnormal conditions thus serves to check if the abnormal condition which caused generation of the trigger signal was removed or not. For maximum safety of the amplifier, this check must take place after the amplifier has been turned off.

The 'confirm' signal is generated after at least one of the two previous signals has been generated and only if the sensing circuit B signals actual persistence of the abnormal condition. This signal is necessary so that the outlet of the sensing circuit B will continue to be enabled to keep the stage off after disappearance of the transient signals 'start-up check' and 'warning', if the abnormal condition persists. Disappearance of the above mentioned signals takes place respectively after the voltage on C1 has passed the upper threshold of the window comparator A and after a time T has elapsed from the falling front of the trigger signal. In the absence of the 'confirm' line, which constitutes a sort of memory for the circuit in question, the amplifier would start always and in any case, even with persistence of the abnormal conditions, upon falling of the other two lines mentioned above.

The greater simplicity of the embodiment shown in FIG. 3 compared with the already advantageous one of FIG. 2 is clear.

During the starting phase, in the absence of abnormal conditions, the stand-by line rises, generating a 'start-up check' signal as soon as the voltage at the ends of C1 passes the lower threshold of A. There is generated an 'amp off enable' signal while the 'fault existing' signal is not generated because there are no abnormal conditions and therefore the circuit means G remain inactive. The 'confirm' signal is not generated. When the voltage on C1 passes the upper threshold of A, the abnormal condition sensing circuit B is no longer enabled to supply signals for turning off the amplifier and therefore terminates the start-up diagnostic phase. The amplifier can be restarted.

If starting takes place in the presence of abnormal conditions which are subsequently removed, the stand-by line generates a 'start-up check' signal as soon as the voltage at the ends of C1 passes the lower threshold of A. An 'amp off enable' signal is generated and also a 'fault existing' signal because there are abnormal conditions and therefore the circuit means G are activated and begin to keep the amplifier off. A 'confirm' signal is also generated. When the voltage at the ends of C1 passes the upper threshold of A the diagnostic circuit continues to prevent the amplifier from starting thanks to the 'confirm' signal even if the 'start-up check' signal is no longer generated. When the abnormal condition is removed, the 'fault existing' signal is no longer generated, nor is the 'confirm' signal. The circuit switching means G then cease to operate and the amplifier can start.

Now let us consider the case of a short circuit during operation followed by removal thereof after a certain time.

Under normal operation conditions the stand-by line is high and the transient voltage at the ends of C1 is exhausted. Therefore the 'start-up check' signal is not generated. Following for example a short circuit, a trigger signal arrives at the output of the monostable L.

On the rising front the monostable is activated raising the 'warning' line, which remains high all the time the trigger signal is present plus a certain time T following disappearance of the trigger signal.

The 'warning' signal first turns off the amplifier (passing through the circuits F and G) and also raises the 'amp off enable' line, thus permitting the gate H to transmit the 'fault existing' signal. If the condition which caused the trigger signal (or any other abnormal condition) remains present the sensing circuit B raises the 'fault existing' line and consequently the 'confirm' line, at the same time keeping the amplifier off through the circuit switching means G. After cessation of the 'warning' signal following return of the monostable M to stable (inactive) condition, the 'confirm' signal continues to enable the sensing circuit B to keep the amplifier off. When the abnormal condition is removed, the 'fault existing' line falls together with the 'confirm' signal and the circuit means G are disabled. The amplifier can thus restart.

In conclusion the invention permits utilisation of a single sensing circuit to detect any persistence of abnormal conditions for all the starting phases and operation of an amplifier, with considerable saving of components, especially for amplifiers having a large number of channels.

It is clear that modification, integration and replacement of elements can be made to the embodiment described above by way of nonlimiting example without thereby going beyond the protective scope of the following claims.

## Claims

1. Circuit for protection of an amplifier stage comprising a double-threshold comparator (A) having at least one input terminal connected to circuit elements for initially turning on the stage and at least one output terminal, a circuit for generating command signals for turn-off of the stage (M) and circuit switching means for turn-off of the stage (G) and characterised in that it comprises a circuit block (L,D,B) for turn-off and restoration of normal stage operation conditions designed to detect any persistence of abnormal conditions at the stage output and generate during said conditions signals for turn-off of the stage, a command signal generator output terminal for turn-off of the stage (M) and the output terminal of the double-threshold comparator (A) being connected to an enablement terminal of the circuit block for turn-off and restoration though a first logic gate circuit of type OR (C), the command signal generator output terminal for turn-off of the stage (M) and an output terminal of the turn-off and restoration circuit block being connected to a command terminal of the circuit switching means (G) through a second logic gate circuit of type OR (F) and in that the command signals for turn-off of the stage have a predetermined duration in time starting from the onset of abnormal operating conditions in the stage.

2. Protection circuit in accordance with claim 1 characterised in that the turn-off and restoration circuit comprises a sensing circuit (B) having at least one access terminal coupled with the output of the stage, an enablement terminal and at least one first terminal and one second terminal for output of signals in mutual phase opposition, the first output terminal being the output terminal of the turn-off and restoration circuit, and a bistable circuit (L) having at least one first input terminal (S) and one second input terminal (R) and an output terminal (Q), the first input terminal, which is the turn-off and restoration circuit enablement terminal, being connected to the output terminal of the first logic gate circuit of type OR (C), which is also connected through an inverter and a logic gate circuit of AND type (D) to the second input terminal of the bistable circuit (L), with said second input terminal there being also connected through the logic gate circuit of AND type (D), the second output terminal of the sensing circuit (B).

3. Protection circuit in accordance with claim 1 characterised in that the turn-off and restoration circuit block comprises a sensing circuit (B) having at least one input terminal coupled with the output of the stage and at least one output terminal and one logic gate circuit AND (H) having at least one first input terminal connected to the output terminal of the sensing circuit (B), a second input terminal which is the turn-off and restoration circuit enablement terminal, and an output terminal which is the turn-off and restoration circuit output terminal, said turn-off and restoration circuit output terminal also being connected to the enablement terminal of the same turn-off and restoration circuit through the first logic gate circuit of type OR (C).

4. Protection circuit in accordance with any one of the above claims characterised in that the signal generating circuit for turn-off of the stage (M) comprises a monostable circuit activated by a pulse generated by 'trigger' type circuit means which detect the current level in output circuit elements of the stage.

## Patentansprüche

1. Schaltung zum Schutz einer Verstärkerstufe, umfassend einen Doppelschwellenwert-Vergleicher (A), der mindestens einen Eingangsanschluß besitzt, der an Schaltungselemente zum anfänglichen Einschalten der Stufe angeschlossen ist, und mindestens einen Ausgangsanschluß besitzt, eine Schaltung zum Generieren von Befehlssignalen zum Abschalten der Stufe (M) und eine Schalteinrichtung zum Abschalten der Stufe (G), und
**dadurch gekennzeichnet,**
daß sie einen Schaltungsblock (L, D, B) zum Ausschalten und Rücksetzen der normalen Betriebsbedingungen der Stufe aufweist, so ausgelegt, daß jegliche Fortdauer abnormaler Zustände am Ausgang der Stufe nachgewiesen wird und während der Zustände Signale zum Ausschalten der Stufe erzeugt werden, wobei ein Befehlssignalgenerator-Ausgangsanschluß zum Ausschalten der Stufe (M) und der Ausgangsanschluß des Doppelschwellenwert-Vergleichers (A) an einen Freigabeanschluß des Schaltungsblocks zum Ausschalten und Zurücksetzen über eine erste logische Gatterschaltung vom Typ ODER (C) angeschlossen sind, der Befehlssignalgenerator-Ausgangsanschluß zum Ausschalten der Stufe (M) und ein Ausgangsanschluß des Ausschalt- und Rücksetz-Schaltungsblocks über eine zweite logische Gatterschaltung vom Typ ODER (F) an einen Befehlsanschluß der Schalteinrichtung (G) gekoppelt sind, und daß die Befehlssignale zum Ausschalten der Stufe eine vorbestimmte Zeitdauer aufweisen, beginnend am Anfang der abnormalen Betriebsbedingungen in der Stufe.

2. Schutzschaltung nach Anspruch 1,
**dadurch gekennzeichnet,**
daß die Abschalt- und Rücksetzschaltung eine Leseschaltung (B) aufweist, die mindestens einen Zugriffanschluß, der mit dem Ausgang der Stufe gekoppelt ist, einen Freigabeanschluß und mindestens einen ersten Anschluß und einen zweiten Anschluß zum Ausgeben von Signalen mit entgegengesetzter Phase aufweist, von denen der erste Ausgangsanschluß der Ausgangsanschluß der Abschalt- und Rücksetzschaltung ist, und eine bestabile Schaltung (L) aufweist, die mindestens einen ersten Eingangsanschluß (S) und einen zweiten Eingangsanschluß (R) sowie einen Ausgangsanschluß (Q) aufweist, von denen der erste Eingangsanschluß, bei dem es sich um den Freigabeanschluß der Abschalt- und Rücksetzschaltung handelt, an den Ausgangsanschluß der ersten logischen Gatterschaltung vom Typ ODER (C) angeschlossen ist, der auch über einen Negator und eine logische Gatterschaltung vom Typ UND (D) an den zweiten Eingangsanschluß der bistabilen Schaltung (L) angeschlossen ist, während der zweite Eingangsanschluß außerdem über die logische Gatterschaltung vom Typ UND (D) an den zweiten Ausgangsanschluß der Leseschaltung (B) angeschlossen ist.

3. Schutzschaltung nach Anspruch 1,
**dadurch gekennzeichnet,**
daß der Abschalt- und Rücksetzschaltungsblock aufweist:
eine Leseschaltung (B), die mindestens einen Eingangsanschluß, der mit dem Ausgang der Stufe gekoppelt ist, und mindestens einen Ausgangsanschluß aufweist, und eine logische Gatterschaltung vom Typ UND (H), die mindestens einen ersten Eingangsanschluß, der an den Ausgang der Leseschaltung (B) gekoppelt ist, einen zweiten Eingangsanschluß, der der Freigabeanschluß der Abschalt- und Rücksetzschaltung ist, und einen Ausgangsanschluß aufweist, welcher der Ausgangsanschluß der Abschalt- und Rücksetzschaltung ist, wobei der Ausgangsanschluß der Abschalt- und Rücksetzschaltung außerdem mit dem Freigabeanschluß derselben Abschalt- und Rücksetzschaltung über die erste logische Gatterschaltung vom Typ ODER (C) gekoppelt ist.

4. Schutzschaltung nach einem der obigen Ansprüche,
**dadurch gekennzeichnet,**
daß die Signalgeneratorschaltung zum Ausschalten der Stufe (M) ein Monoflop aufweist, welches durch einen Impuls aktiviert wird, der von einer Triggerschaltung erzeugt wird, die den Strompegel in Ausgangsschaltungselementen der Stufe erfaßt.

## Revendications

1. Circuit de protection d'un étage amplificateur comprenant un comparateur à double-seuil (A) présentant au moins une borne d'entrée reliée à des éléments de circuit destinés à mettre en circuit initialement l'étage et au moins une borne de sortie, un circuit permettant de générer des signaux de commande de mise hors circuit de l'étage (M) et des moyens de commutation de circuit pour mettre hors circuit l'étage (G), et caractérisé en ce qu'il comprend un bloc de circuit (L, D, 8) permettant de mettre hors circuit et de rétablir des conditions de fonctionnement normales de l'étage, conçu pour détecter toute persistance de conditions anormales à la sortie de l'étage et pour générer pendant ces dites conditions des signaux de mise hors circuit de l'étage, une borne de sortie du générateur de signaux de commande pour mettre hors circuit l'étage (M) et la borne de sortie du comparateur double-seuil (A) étant reliées à une borne de validation du bloc de circuit permettant la mise hors circuit et le rétablissement par le biais d'un premier circuit logique de type OU (C), la borne de sortie du générateur de signaux de commande pour mettre hors circuit l'étage (M) et une borne de sortie du bloc de circuit de mise hors circuit et de rétablissement étant reliées à une borne de commande des moyens de commutation de circuit (G) par le biais d'un second circuit logique de type OU (F), et en ce que les signaux de commande de mise hors circuit de l'étage présentent une durée prédéterminée à partir de la survenue des conditions anormales de fonctionnement dans l'étage.

2. Circuit protecteur selon la revendication 1, caractérisé en ce que le circuit de mise hors circuit et de rétablissement comprend un circuit détecteur (B) présentant au moins une borne d'accès reliée à la sortie de l'étage, une borne de validation et au moins une première borne et une seconde borne pour la sortie de signaux en opposition de phase mutuelle, la première borne de sortie étant la borne de sortie du circuit de mise hors circuit et de rétablissement, et un circuit bistable (L) présentant au moins une première borne d'entrée (S), une seconde borne d'entrée (R) et une borne de sortie (Q), la première borne d'entrée, qui est la borne de validation du circuit de mise hors circuit et de rétablissement, étant reliée à la borne de sortie du premier circuit logique de type OU (C), laquelle est également reliée par le biais d'un inverseur et d'un circuit logique de type ET (D) à la seconde borne d'entrée du circuit bistable (L), ladite seconde borne d'entrée étant également reliée, par le biais du circuit logique de type ET (D), à la seconde borne de sortie du circuit détecteur (B).

3. Circuit protecteur selon la revendication 1, caractérisé en ce que le bloc de circuit de mise hors circuit et de rétablissement comprend un circuit détecteur (B) présentant au moins une borne d'entrée reliée à la sortie de l'étage et au moins une borne de sortie et un circuit logique ET (H) présentant au moins une première borne d'entrée reliée à la borne de sortie du circuit détecteur (B), une seconde borne d'entrée, qui est la borne de validation du circuit de mise hors circuit et de rétablissement, et une borne de sortie qui est la borne de sortie du circuit de mise hors circuit et de rétablissement, ladite borne de sortie du circuit de mise hors circuit et de rétablissement étant également reliée à la borne de validation de ce même circuit de mise hors circuit et de rétablissement par le biais du premier circuit logique de type OU (C).

4. Circuit protecteur selon l'une des revendications précédentes, caractérisé en ce que le circuit générateur de signaux de mise hors circuit de l'étage (M) comprend un circuit monostable activé par une impulsion générée par un circuit de type "à déclenchement" qui détecte le niveau de courant dans les éléments de sortie de l'étage.
